**Europäisches Patentamt**

**European Patent Office**

**Office européen des brevets**

(11) Publication number: **0 190 162**
**B1**

# EUROPEAN PATENT SPECIFICATION

(45) Date of publication of patent specification: **07.11.90**

(21) Application number: **85903103.1**

(22) Date of filing: **31.05.85**

(86) International application number:
**PCT/US85/01002**

(87) International publication number:
**WO 86/00469 16.01.86 Gazette 86/02**

(51) Int. Cl.⁵: **H 01 L 29/74**

(54) **CONTROLLED TURN-ON THYRISTOR.**

(30) Priority: **29.06.84 US 626165**

(43) Date of publication of application:
**13.08.86 Bulletin 86/33**

(45) Publication of the grant of the patent:
**07.11.90 Bulletin 90/45**

(84) Designated Contracting States:
**CH DE FR GB LI SE**

(56) References cited:
**US-A-3 246 172     US-A-4 012 761**
**US-A-3 248 677     US-A-4 261 001**
**US-A-3 408 545     US-A-4 281 336**
**US-A-3 671 821     US-A-4 314 266**
**US-A-3 967 294     US-A-4 500 901**

**IEEE TRANSACTIONS ON ELECTRON DEVICES,
vol. ED-30, no. 7, July 1983, pages 816-824, IEEE,
New York, US; V.A.K. TEMPLE: "Controlled
turn-on thyristors"**

(73) Proprietor: **GENERAL ELECTRIC COMPANY
1 River Road
Schenectady New York 12305 (US)**

(72) Inventor: **TEMPLE, Victor, Albert, Keith
Main Street
Clifton Park, NY 12065 (US)**

(74) Representative: **Kennington, Eric Alasdair et al
. . RCA International Limited Burdett House 15-16
Buckingham Street
London WC2N 6DU (GB)**

(56) References cited:

**PATENT ABSTRACTS OF JAPAN, vol. 5, no. 198
(E-87)870r, 16th December 1981; & JP-A-56 122
165 (TOKYO SHIBAURA DENKI K.K.) 25-09-1981**

**IEEE TRANSACTIONS ON POWER APPARATUS
AND SYSTEMS, VOLUME PAS-101, NUMBER 7,
JULY 1982, PAGES 1 - 6.**

**Solid State and Semiconductor Physics,
J.P.Kelvey, Harper & Row Publishers, pp. 325,
326.**

Courier Press, Leamington Spa, England.

(56) References cited:

**Modern Power Devices, J.Baliga, John Wiley &
Sons, pp.11,12; 392, 393.**

## Description

The present invention relates to multistage amplifying thyristors with gate and main stages and, more particularly, relates to a multistage amplifying thyristor in which the peak turn-on current in the gate and any intermediate thyristor stages is limited during thyristor turn-on.

Conventional multistage amplifying thyristors include gate and main stages and may include one or more intermediate stages. The reason for including several stages in a thyristor is to permit turn-on of the thyristor with a gate signal of very low energy. For example, a light triggered thyristor (LTT) must rely upon a minute amount of light energy (typically on the order of about 20 nanojoules) to turn on the thyristor. This is possible since the light energy turns on only a gate thyristor stage which is highly-sensitive but of low current rating and which, in turn, turns on any intermediate thyristor stage. Successive turn-on of the various thyristor stages continues until turn-on of the main thyristor stage is turned on.

A significant limitation of conventional multistage amplifying thyristors is that the rate of turn-on, or di/dt, of such thyristors used in typical circuits must be controlled by external circuit devices in order to prevent thermal stresses in the thyristor from destroying the thyristor. For instance, a typical high voltage direct current transmission system utilizing thyristors for alternating current-to-direct current conversion incorporates relatively expensive saturable reactors. This type of reactor presents a temporary, high inductive impedance to turn-on current flow in a thyristor, but rapidly falls off in its level of inductive impedance upon steady state thyristor operation.

A published approach to designing a thyristor with enhanced immunity from di/dt thermal stress failure, known as the controlled turn-on approach, is to incorporate into a multistage amplifying thyristor current control resistor regions, one between each pair of adjacent thyristor stages. These current control resistor regions are intended to reduce turn-on, or di/dt, thermal stress in a thyristor by functioning to, first, reduce the current in each preceding or prior turned-on thyristor stage and, second, reduce the duty cycle of each preceding thyristor stage. The subject approach is described in detail, for example, in an article by VAK Temple (the present inventor) entitled "Controlled Turn-on Thyristors" published in IEEE Transactions on Electron Devices, Vol. ED-30 (July 1983) at pages 816—824, the entirety of this article being incorporated herein by reference.

The foregoing Temple article describes successful performance of 5 kilovolt thyristors that were tested to a 600 volt level. Subsequent testing of thyristors such as described in the Temple article by the present inventor has shown the occurrence of turn-on failure, due to thermal stresses, at about the 2000 volt level. Further investigation into the controlled turn-on approach described in the Temple article has revealed that certain considerations, not taken into account in the investigation described in the article, are a factor in causing turn-on failure at about the 2000 volt level. The present invention addresses these considerations and results in a multistage amplifying thyristor successfully exhibiting controlled turn-on at considerably higher voltages than heretofore attainable.

In general terms, the considerations not addressed in the Temple article are centered around the decrease in resistance value of the current control resistor regions incorporated into a thyristor, due to what is known in the art as a "modulation" effect in such resistor regions. It is important to note that these resistor regions comprise semiconductor material of nominal doping concentration and of either P- or N-conductivity type. The increase in either majority or minority carrier concentration in the current control resistor regions results in modulation, or lowering, of the resistance of such regions. This is readily appreciated in the case of increased majority carrier concentration due to the overall increase in concentration of majority carriers; however, in the case of increased minority carrier concentration, an additional phenomenon known in the art as the principle of quasi-neutrality is involved. In accordance with this principle, the concentration of majority carriers in a semiconductor region increases to roughly that of the minority carrier concentration, preventing unduly high electric fields from occurring in the thyristor.

The Temple article points out that within a multistage amplifying thyristor, there are sources of mobile carriers (in particular, the cathode emitter layers of the various thyristor stages) that increase the current carrier level in the current control resistor regions, unless these regions are sufficiently spaced or otherwise shielded from such sources of carriers. The present invention is directed to a thyristor design in which further sources of mobile carriers, not recognized at the time of publication of the Temple article, are spaced or shielded from such sources of mobile carriers by an extent sufficient to minimize modulation of the current control resistor regions.

According to the invention, there is provided a multistage amplifying thyristor including a semiconductor body (12), a first emitter electrode (13), inner (16) and outer (18) stage emitter electrodes, and a current control resistor region (20);

said semiconductor body comprising a first emitter layer (24), a first base layer (26) atop said first emitter layer, a second base layer (28) atop said first base layer, an inner stage emitter layer (30) atop said second base layer and an outer stage emitter layer (32) atop said second base layer and which is adjacent to and situated in an outward direction from said inner stage emitter layer;

said first emitter electrode (13) underlying said first emitter layer;

said inner stage emitter electrode (16) in a first part (16a) overlying said inner stage emitter layer (30) and in a second part (16b), situated outwardly from said first part, overlying said second base layer (28);

said outer stage emitter electrode (18) overlying said outer stage emitter layer (32);

said current control resistor region (20) constituting a portion of said second base region (28) defined on an inner side by an outer edge (16b') of said inner stage emitter electrode (16) and extending towards but spaced from said outer stage emitter layer (32);

said current control resistor region (20) having an unmodulated resistance selected to limit to a safe level the turn-on current in each preceding amplifying thyristor stage;

characterized in that:

the outer edge (16b') of said inner stage emitter electrode (16) is spaced outwardly by a predetermined distance (72'', 72, 72') which is the greater of at least one thickness of said semiconductor body and at least two ambipolar diffusion lengths in said first base layer from any of:

an inner edge (76) of said inner stage emitter layer (30),

an outer edge (70) of turn-on plasma beneath said inner stage emitter layer (30), and

an outer edge (74) of said inner stage emitter layer (30).

Utilizing the above-described spacing of the current control resistor region from the inner stage emitter layer, carrier injection from a portion of emitter layer situated beneath the inner stage emitter layer is prevented from modulating the current control resistor region.

Brief description of the drawings

The invention, both as to organization and method of operation, may be better understood with reference to the following illustrative description when read in conjunction with the accompanying drawings, in which:

Figure 1 is a cross-sectional view of a portion of a thyristor incorporating features of the present invention;

Figure 2 is a schematic electrical circuit equivalent of the thyristor of Figure 1;

Figure 3 depicts the thyristor of Figure 1 and illustrates a source of mobile carriers that may result in unwanted modulation;

Figures 4A—4C depict variations of the thyristor of Figure 1 and illustrate different arrangements for spacing a current control resistor region from a first stage $N^+$ emitter layer of the thyristor, which spacing minimizes modulation of the current control resistor region;

Figure 5 depicts a further thyristor of the present invention incorporating an intermediate stage and indicates exemplary dimensions of various parts of the thyristor; and

Figure 6 is a fragmentary view of a current control resistor region that may be used in the Figure 1 thyristor, illustrating, in particular, a multi-zoned current control resistor region for equalizing thermal stresses in the various zones of the region.

Detailed description of the preferred embodiments

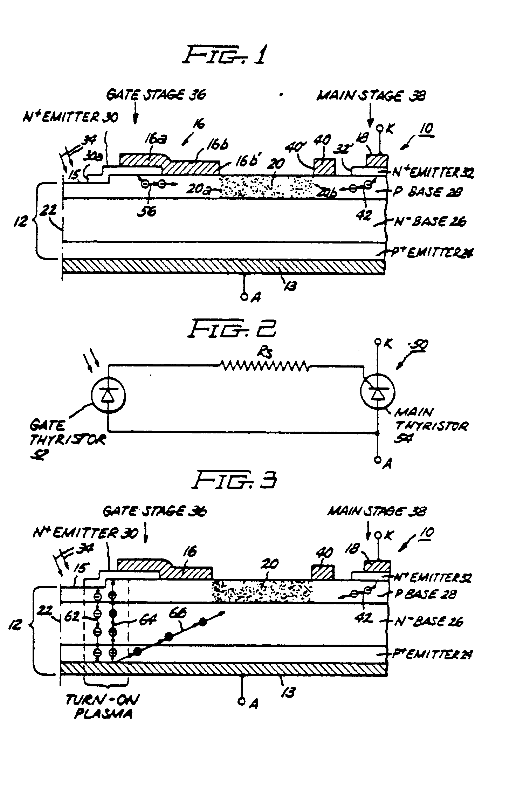

Depicted in Figure 1 is a multistage amplifying thyristor 10 incorporating features of the present invention. Thyristor 10 includes a semiconductor body 12, such as silicon, a first emitter electrode 13, inner and outer stage emitter electrodes 16 and 18, respectively, and a current control resistor region 20. As viewed from above in Figure 1, thyristor 10 is circular in shape, by way of example, with a center illustrated in Figure 1 as center line 22. Inner and outer stage emitter electrodes 16 and 18, respectively, appear, as viewed from above in Figure 1, as annular in shape.

Semiconductor body 12 includes a $P^+$ emitter layer 24, $N^-$ base layer 26 atop emitter layer 24, P base layer 28 atop base layer 26, an $N^+$ emitter layer 30 atop base layer 28, and an $N^+$ emitter layer 32 atop base layer 28 and which is adjacent to and situated in an outward direction from emitter layer 30, an "outward" direction signifying herein radially outward from center line 22. Depression 15 in P base layer 28, into which an inner edge 30a of $N^+$ emitter layer 30 extends, constitutes a gate area onto which radiation, such as light radiation 38, impinges for initiating turn-on of thyristor 10. $N^+$ emitter layer 30 constitutes the emitter of an inner thyristor stage 36, comprising a gate thyristor stage, while emitter layer 32 constitutes the emitter of an outer thyristor stage 38, that may comprise an intermediate or a main thyristor stage.

First emitter electrode 13 underlies $P^+$ emitter layer 24 and is designated "A", for "anode". Inner stage emitter electrode 16 in a first part 16a overlies emitter layer 30 and in a second part 16b, situated outwardly from first part 16a, overlies P base layer 28. Main stage emitter electrode 18 overlies $N^+$ emitter layer 32 and is designated "K" for "cathode". The foregoing electrodes 13, 16 and 18 preferably comprise aluminum.

Further included in thyristor 10 is a recombination ring 40, such as aluminum, the purposes of which are elaborated on below.

Current control resistor region 20 constitutes a portion of P base layer 28 having its inner side 20a extending as far as an outward edge 16b' of inner stage emitter electrode 16 and having its outward edge 20b extending as far as an inner edge 40' of recombination ring 40.

Current control resistor region 20 has an unmodulated resistance between inner and outer sides 20a and 20b that is selected to limit to a safe level the turn-on current in the preceding, or gate stage 36, of thyristor 10. Selection of an appropriate value for the unmodulated resistance of resistor region 20 is discussed in the above-referenced Temple article. Fabrication of resistor region 20 is suitably accomplished by providing a suitable spacing between inner and outer resistor sides 20a and 20b without there being a need to specially alter the doping level (and hence, resistivity) of P base layer 28. Alternatively, the doping concentration of resistor region 20 can be specially adjusted by ion implantation of suitable dopant, for example, whereby the separation between resistor sides 20a and 20b can be controlled independently of the doping level of the remainder of P base layer 28.

The purposes of current control resistor region 20 can be better understood with reference to the Figure 2 illustration of electrical circuit 50, which is the circuit equivalent of thyristor 10 of Figure 1. Gate and main thyristors 52 and 54, respectively, of electrical circuit 50 correspond to the gate and main stages 36 and 38, respectively, of thyristor 10, while the interstage series resistance $R_s$ between thyristors 52 and 54 corresponds to the net device resistance between inner and outer stage emitter electrodes 16 and 18, respectively, of thyristor 10.

Interstage resistance $R_s$ in circuit 50 provides two protective features in circuit 50; first, it limits current flow in gate thyristor 52 while main thyristor 54 is turned on, and, second, it reduces the duration of time that gate thyristor 52 conducts current when thyristor 10 is turning on, since current through main thyristor 54, once this thyristor is turned on and thus in a low impedance state, is favored over current through gate thyristor 52, which must flow through interstage resistance $R_s$.

Interstage resistance $R_s$ contains components that are modulated during turn-on of circuit 50 (corresponding to turn-on of thyristor 10) to reduce the resistance value of $R_s$ during this period of time. It is preferred that the modulated component of $R_s$ not exceed about 10 percent of the unmodulated $R_s$ value, although modulation as high as about 20 percent is believed to be acceptable.

The modulated components of resistance $R_s$ can be understood by considering the analogous structure of thyristor 10 corresponding to resistance $R_s$ of circuit 50. The thyristor 10 equivalent of resistance $R_s$ constitutes the net resistance between inner and outer stage emitter electrodes 16 and 18 as measured with emitter electrodes 16 and 18 free-floating in potential. Such net resistance contains modulated components during turn-on of thyristor 10 which are due, for example, to injection into P base layer 28 from $N^+$ emitter layer 30 of electrons depicted by path 56 and injection into P base layer 28 of electrons depicted by path 42 from $N^+$ emitter layer 32. To prevent electrons in path 42 from reaching resistor region 20 and modulating such region, recombination ring 40 removes electrons 42 in path from P base layer 28 in its function as a carrier recombination region. Even with recombination ring 40 present, spacing of inner edge 40' of recombination ring 40 from inner edge 32' of $N^+$ emitter layer 32 by at least about two minority carrier diffusion lengths in P base layer 28 is desirable.

Recombination ring 40 is also desirable for homogenizing the current transferred from gate stage 36 to main stage 38 of thyristor 10 during device turn-on. Ring 40, however, may be deleted from thyristor 10 as long as adequate spacing is provided between $N^+$ emitter layer 32 and current control resistor region 20, spacing of about three minority carrier diffusion lengths in P base layer 28 being suitable, by way of example.

The above-referenced Temple article points out that modulation of a current control resistor region may occur as a result of carrier injection from gate and main stage emitter layers into a P base layer (see the Temple article at page 823, in Fig. 12(c) and discussion thereof). The Temple article indicates successful attainment of the objective of safe turn-on of a thyristor, but this was verified only at the 600 volt level for a 5 kilovolt device (see the Temple article page 819, seventh paragraph). Further thyristor testing and development has shown that modulation in current control resistor region 20 from a source of carriers other than $N^+$ emitter layers 30 and 32 must be taken into account.

An additional source of carriers that may result in modulation of current control resistor region 20 is illustrated in Figure 3, depicting the same view of thyristor 10 as shown in Figure 1, and, further, schematically illustrating a turn-on plasma 60 beneath $N^+$ emitter layer 30. Plasma 60 comprises electrons in path 62 injected from $N^+$ emitter layer 30 into $P^+$ emitter layer 24 and the returning holes in path 64 injected from $P^+$ emitter layer 24. The concentration of holes and electrons in plasma 60 is typically about $10^{17}$ per cubic centimeter for each type of current carrier. Functionally, plasma 60 is the portion of gate stage 36 that turns on when turn-on radiation 34, such as light, impinges upon gate depression 15 so as to generate hole-electron pair turn-on current. Some portion of hole current 66 from turn-on plasma 60 does not remain confined to the high density plasma, but instead becomes attracted to the current control resistor region 20. This attraction occurs because main stage emitter electrode 18 is typically biased to several thousand volts prior to turn-on of main stage 38, while, once gate 36 has turned on, inner stage emitter electrode 16 falls off in voltage intensity due to its low impedance connection, via turn-on plasma 60, to emitter electrode 13.

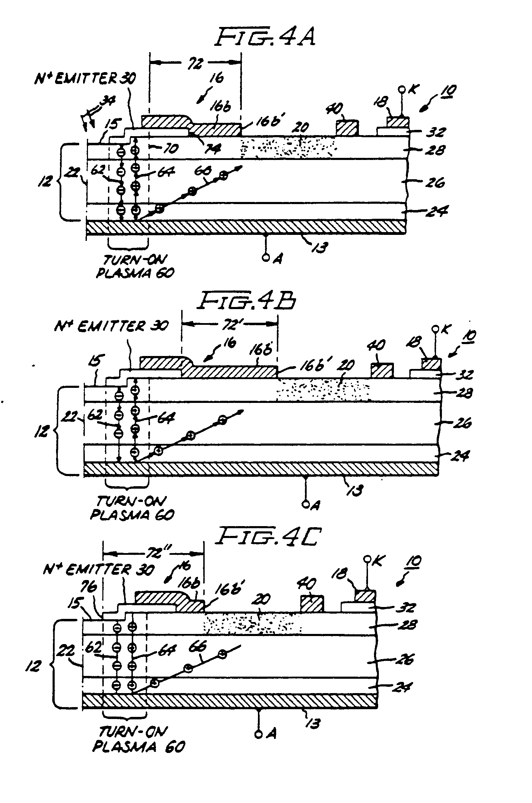

To counteract the tendency of holes in path 66 from entering and thus modulating current control resistor region 20, adequate spacing between turn-on plasma 60 and the current control resistor region is provided as depicted in Figure 4A, illustrating the same view as Figure 1. In particular, modulation of region 20 by holes in path 66 is avoided if outer edge 16b' of first stage emitter electrode 16 is spaced from an outer edge 70 of turn-on plasma 60 by a predetermined distance 72 of at least about the greater of one thickness of semiconductor body 12 and two ambipolar diffusion lengths (a standard design parameter) in $N^-$ base layer 26. More conservative values for predetermined distance 72 are at least the greater of any of: two thicknesses of semiconductor body 12 and two ambipolar diffusion lengths in $N^-$ base layer 26; two body thicknesses and three ambipolar diffusion lengths in layer 26; three body thicknesses and two ambipolar diffusion lengths in layer 26; and three body thicknesses and three ambipolar diffusion lengths in layer 26. The location of outer edge 70 of turn-on plasma 60 may be readily determined according to known principles in the art. An alternative spacing arrangement, shown in Figure 4B, is to space inner stage emitter electrode outer edge 16' from an outer edge 74 of N$^+$ emitter layer 30 by a predetermined distance 72', which is of equal measure to predetermined distance 72 (indicated in Figure 4A). A further alternative spacing arrangement, shown in Figure 4C, is to space first stage emitter electrode outer edge 16b' from inner edge 76 of N$^+$ emitter layer 30 by a predetermined distance of 72', which is of equal measure to predetermined distance 72 (indicated in Figure 4A). In selecting one of the spacing arrangements of Figures 4A—4C, it is a general consideration that the longer part 16b (of inner stage emitter electrode 16) is, the less likely it is for resistor region 20 to be undesirably modulated.

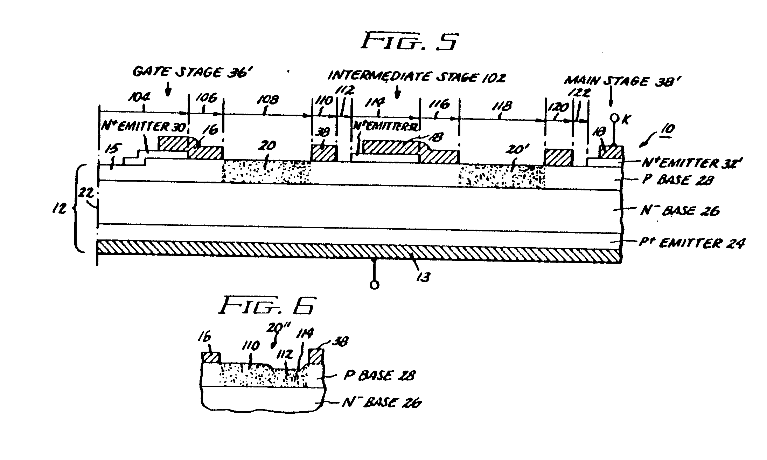

By way of example and not limitation, a 4.5 kilovolt light triggered thyristor 100, shown in Figure 5, was constructed in accordance with the present invention. Thyristor 100 includes an intermediate stage 102, corresponding to main stage 38 of thyristor 10 (Fig. 1). Light triggered thyristor 100 exhibited safe turn-on at the 4 kilovolt level with a di/dt value of about 450 amps per microsecond and with heat sink temperatures on different testing runs from 38 to 90° Centigrade. The tested thyristor had the following dimensions in mils (and mm) where 1 mil$=10^{-3}$ inches: radial distance 104 of 25 mils (0.63 mm); radial distance 106 (which includes distance 104) of 65 mils (1.65 mm); and radial distances 108, 110, 112, 114, 116, 118, 120 and 122 of, respectively, 120 mils (3.05 mm), 130 mils (3.3 mm), 140 mils (3.56 mm), 165 mils (4.19 mm), 190 mils (4.83 mm), 275 mils (6.98 mm) and 288 mils (7.31 mm). The approximate resistance of current control resistor region 20 and 20' was, respectively, 98 ohms and 50 ohms.

If the amperage rating of thyristor 10 (Fig. 1) is very high, it is desirable to construct current control resistor region 20 in such a way as to more evenly spread the thermal stresses radially across the region. A preferred technique for accomplishing this is illustrated in Figure 6, depicting a fragmentary view of a modified region 20''. This region includes first and second zones 110 and 112, respectively, with zone 112 being located outwardly of zone 110 and being thinner, and thus of higher resistance, than zone 110. Zone 112 may be implemented, for example by an etch step (not illustrated) that removes an upper portion of P base layer 28 down to level 114. This etch step may advantageously be carried out simultaneously with the etch step for gate depression 15 of gate stags 36 of thyristor 10 (Fig. 1). Zones 110 and 112 dissipate approximately the same amount of heat per unit volume as each other since the higher (current)$^2$×resistance heating of zone 112 is dissipated in a larger volume, zone 112 being of larger volume since it is located radially outward of zone 110.

Although not illustrated, current control resistor zone 20 may also be implemented as a series of zones of increasing resistance with increasing radial spacing. This could be accomplished, for example, by providing a series of successively thinner zones in a current control resistor region extending in the outward direction. As an alternative to utilizing thinner zones for higher resistance, zones of higher resistance could be implemented by ion implantation of suitable dopant, with a high resistance zone having a low dopant concentration, for example.

Fabrication of the above-described thyristors may be carried out with conventional semiconductor device processing techniques and will be within the purview of those skilled in the thyristor art in light of the present specifications.

The foregoing describes a multistage amplifying thyristor having a reliable turn-on characteristic incorporating built-in or integrated current control resistor regions between adjacent thyristor stages for limiting current in all but the main thyristor stage. The thyristor accordingly achieves essential immunity from di/dt turn-on failure without the need for external circuitry to limit the di/dt value of the thyristor.

While only certain preferred features of the invention have been shown by way of illustration, many modifications and changes will occur to those skilled in the thyristor art. For example, complementary thyristors could be made in which P-conductivity type semiconductor material is substituted for N-conductivity type material, and vice-versa.

**Claims**

1. A multistage amplifying thyristor including a semiconductor body (12), a first emitter electrode (13), inner (16) and outer (18) stage emitter electrodes, and a current control resistor region (20);

said semiconductor body comprising a first emitter layer (24), a first base layer (26) atop said first emitter layer, a second base layer (28) atop said first base layer, an inner stage emitter layer (30) atop said second base layer and an outer stage emitter layer (32) atop said second base layer and which is adjacent to and situated in an outward direction from said inner stage emitter layer;

said first emitter electrode (13) underlying said first emitter layer;

said inner stage emitter electrode (16) in a first part (16a) overlying said inner stage emitter layer (30) and in a second part (16b), situated outwardly from said first part, overlying said second base layer (28);

said outer stage emitter electrode (18) overlying said outer stage emitter layer (32);

said current control resistor region (20) constituting a portion of said second base region (28) defined on an inner side by an outer edge (16b) of said inner stage emitter electrode (16) and extending towards but spaced from said outer stage emitter layer (32);

said current control resistor region (20) having an unmodulated resistance selected to limit to a safe level the turn-on current in each preceding amplifying thyristor stage;

characterized in that:

the outer edge (16b') of said inner stage emitter electrode (16) is spaced outwardly by a predetermined distance (72'', 72, 72') which is the greater of at least one thickness of said semiconductor body and at least two ambipolar diffusion lengths in said first base layer from any of:

an inner edge (76) of said inner stage emitter layer (30),

an outer edge (70) of turn-on plasma beneath said inner stage emitter layer (30), and

an outer edge (74) of said inner stage emitter layer (30).

2. The thyristor of Claim 1 wherein the said predetermined distance is the greater of at least two thicknesses of said semiconductor body (12) and at least two ambipolar diffusion lengths of said first base layer (26).

3. The thyristor of Claim 1 wherein the said predetermined distance is the greater of at least two thicknesses of said semiconductor body (12) and at leat three ambipolar diffusion lengths in said first base layer (26).

4. The thyristor of Claim 1 wherein the said predetermined distance is the greater of at least three thicknesses of said semiconductor body (12) and at least two ambipolar diffusion lengths in said first base layer (26).

5. The thyristor of Claim 1 wherein the said predetermined distance is the greater of at least three thicknesses of said semiconductor body (12) and at least three ambipolar diffusion lengths in said first base layer (26).

6. The thyristor of Claim 1, 2, 3, 4 or 5 wherein said outer edge (16b') of the inner stage emitter electrode (16) extends outwardly by said predetermined distance (72) from the outer edge (70) of the turn-on plasma beneath said inner stage emitter layer.

7. The thyristor of Claim 1, 2, 3, 4 or 5 wherein said outer edge (16b') of the inner stage emitter electrode (16) extends outwardly by said predetermined distance (72) from the outer edge (74) of said inner stage emitter layer (30).

8. The thyristor of Claim 1, 2, 3, 4 or 5 wherein said outer edge (16b') of said inner stage emitter electrode (16) extends outwardly by said predetermined distance (72') from the outer edge of said inner stage emitter layer (30).

9. The thyristor of any preceding Claim wherein said control resistor emitter region (20) comprises at least two zones with the outer zone having a higher resistance than the inner zone.

10. The thyristor of Claim 9 wherein said outer zone of said current control resistor region (20) is thinner than said inner zone of said current control resistor region.

**Patentansprüche**

1. Vielstufiger verstärkender Thyristor mit einem Halbleiterkörper (12), einer ersten Emitterelektrode (13), Emitterelektroden einer inneren (16) und einer äußeren (18) Stufe und einem Stromsteuerungs-Widerstandstandsbereich (20),

wobei der Halbleiterkörper eine erste Emitterschicht (24), eine erste Basisschicht (26) auf der Emitterschicht, eine zweite Basisschicht (28) auf der ersten Basisschicht, eine Emitterschicht (30) einer inneren Stufe auf der zweiten Basisschicht und eine Emitterschicht (32) eine äußeren Stufe aufweist, die auf der zweiten Basisschicht angeordnet und die neben und in einer Auswärtsrichtung von der Emitterschicht der inneren Stufe angeordnet ist,

die erste Emitterelektrode (13) unter der ersten Emitterschicht liegt,

die Emitterelektrode (16) der inneren Stufe in einem ersten Teil (16a) über der Emitterschicht (30) der inneren Stufe und in einem zweiten Teil (16b), der sich außen von dem ersten Teil befindet, über der zweiten Basisschicht (28) liegt,

die Emitterelektrode (18) der äußeren Stufe über der Emitterschicht (32) der äußeren Stufe liegt,

der Stromsteuerungs-Widerstandsbereich (20) einen Teil des zweiten Basisbereichs (28) bildet, der auf einer inneren Seite durch einen äußeren Rand (16b) der Emitterelektrode (16) der inneren Stufe gebildet ist und sich in Richtung auf die Emitterschicht (32) der äußeren Stufe erstreckt, aber im Abstand davon angeordnet ist,

der Stromsteuerungs-Widerstandsbereich (20) einen unmodulierten Widerstand aufweist, der so gewählt ist, daß der Einschaltstrom in jeder vorhergehenden verstärkenden Thyristorstufe auf einen sicheren Wert begrenzt ist, dadurch gekennzeichnet, daß:

der äußere Rand (16b') der Emitterelektrode (16) der inneren Stufe nach außen beabstandet ist um eine vorbestimmte Strecke (72'', 72, 72'), die die größere von wenigstens einer Dicke des Halbleiterkörpers und wenigstens zwei ambipolaren Diffusionslängen in der ersten Basisschicht ist von einem der folgenden Ränder:

einem inneren Rand (76) der Emitterschicht (30) der inneren Stufe,

einem äußeren Rand (70) des Einschaltplasmas unterhalb der Emitterschicht (30) der inneren Stufe und

einem äußeren Rand (74) der Emitterschicht (30) der inneren Stufe.

2. Thyristor nach Anspruch 1, wobei die vorbestimmte Strecke die größere von wenigstens zwei Dicken des Halbleiterkörpers (12) und wenigstens zwei ambipolaren Diffusionslängen der ersten Basisschicht (26) ist.

3. Thyristor nach Anspruch 1, wobei die vorbestimmte Strecke die größere von wenigstens zwei Dicken des Halbleiterkörpers (12) und wenigstens drei ambipolaren Diffusionslängen in der ersten Basisschicht (26) ist.

4. Thyristor nach Anspruch 1, wobei die vorbestimmte Strecke die größere von wenigstens drei Dicken des Halbleiterkörpers (12) und wenigstens zwei ambipolaren Diffusionslängen in der ersten Basisschicht (26) ist.

5. Thyristor nach Anspruch 1, wobei die vorbestimmte Strecke die größere von wenigstens drei Dicken des Halbleiterkörpers (12) und wenigstens drei ambipolaren Diffusionslängen in der ersten Basisschicht (26) ist.

6. Thyristor nach Anspruch 1, 2, 3, 4 oder 5, wobei der äußere Rand (16b') der Emitterelektrode (16) der inneren Stufe sich nach außen erstreckt um die vorbestimmte Strecke (72) von dem äußeren Rand (70) des Einschaltplasmas unterhalb der Emitterschicht der inneren Stufe.

7. Thyristor nach Anspruch 1, 2, 3, 4 oder 5, wobei der äußere Rand (16b') der Emitterelektrode (16) der inneren Stufe sich nach außen erstreckt um die vorbestimmte Strecke (72) von dem äußeren Rand (74) der Emitterschicht (30) der inneren Stufe.

8. Thyristor nach Anspruch 1, 2, 3, 4 oder 5, wobei der äußere Rand (16b') der Emitterelektrode (16) der inneren Stufe sich nach außen erstreckt um die vorbestimmte Strecke (72') von dem äußeren Rand der Emitterschicht (30) der inneren Stufe.

9. Thyristor nach einem der vorstehenden Ansprüche 1 bis 8, wobei der Steuerwiderstands-Emitterbereich (20) wenigstens zwei Zonen aufweist, wobei die äußere Zone einen höheren Widerstand als die innere Zone aufweist.

10. Thyristor nach Anspruch 9, wobei die äußere zone des Stromsteuerungs-Widerstandsbereiches (20) dünner ist als die innere Zone des Stromsteuerungs-Widerstandsbereiches.

**Revendications**

1. Thyristor à amplification à plusieurs étages comprenant un corps semiconducteur (12), une première électrode d'émetteur (13), des électrodes d'émetteur d'étages interne (16) et externe (18), et une région de résistance de régulation de courant (20);

le corps semiconducteur comprenant une première couche d'émetteur (24), une première couche de base (26) au-dessus de la première couche d'émetteur, une seconde couche de base (28) au-dessus de la première couche de base, une couche d'émetteur d'étage interne (30) au-dessus de la seconde couche de base, et une couche d'émetteur d'étage externe (32) au-dessus de la seconde couche de base, cette dernière étant adjacente et située vers l'extérieur par rapport à la couche d'émetteur d'étage interne;

la première électrode d'émetteur (13) se trouvant sous la première couche d'émetteur;

l'électrode d'émetteur d'étage interne (16) se trouvant, dans une première partie (16a) au-dessus de la couche d'émetteur d'étage interne (30) et, dans une seconde partie (16b), à l'extérieur par rapport à la première partie, au-dessus de la seconde couche de base (28);

l'électrode d'émetteur d'étage externe (18) se trouvant au-dessus de la couche d'émetteur d'étage externe (32);

la région de résistance de régulation de courant (20) constituant une partie de la seconde couche de base (28) définie d'un côté interne par un bord externe (16b) de l'électrode d'émetteur d'étage interne (16) et s'étendant vers la couche d'émetteur d'étage externe (32) tout en en étant espacée;

la région de résistance de régulation de courant (20) présentant une résistance non modulée choisie pour limiter à un niveau de sécurité le courant de mise en conduction dans chaque étage précédent du thyristor à amplification;

caractérisé en ce que:

le bord externe (16b') de l'électrode d'émetteur d'étage interne (16) est espacé vers l'extérieur d'une distance prédéterminée (72'', 72, 72') qui est la plus grande parmi les valeurs suivantes: au moins une épaisseur du corps semiconducteur et au moins deux longueurs de diffusion ambipolaire dans la première couche de base, à partir de:

un bord interne (76) de la couche d'émetteur d'étage interne (30),

un bord externe (70) du plasma de mise en conduction en-dessous de la couche d'émetteur d'étage interne (30), ou

un bord externe (74) de la couche d'émetteur d'étage interne (30).

2. Thyristor selon la revendication 1, dans lequel ladite distance prédéterminée est la plus grande d'au moins deux épaisseurs du corps semiconducteur (12) et d'au moins deux longueurs de diffusion ambipolaire dans la première couche de base (26).

3. Thyristor selon la revendication 1, dans lequel ladite distance prédéterminée est la plus grande d'au moins deux épaisseurs du corps semiconducteur (12) et d'au moins trois longueurs de diffusion ambipolaire dans la première couche de base (26).

4. Thyristor selon la revendication 1, dans lequel ladite distance prédéterminée est la plus grande d'au moins trois épaisseurs du corps semiconducteur (12) et d'au moins deux longueurs de diffusion ambipolaire dans la première couche de base (26).

5. Thyristor selon la revendication 1, dans lequel ladite distance prédéterminée est la plus grande d'au moins trois épaisseurs du corps semiconducteur (12) et d'au moins trois longueurs de diffusion ambipolaire dans la première couche de base (26).

6. Thyristor selon la revendication 1, 2, 3, 4 ou 5, dans lequel le bord externe (16b') de l'électrode d'émetteur d'étage interne (16) s'étend vers l'extérieur de ladite distance prédéterminée (72) à partir du bord externe (70) du plasma de mise en conduction en dessous de la couche d'émetteur d'étage interne.

7. Thyristor selon la revendication 1, 2, 3, 4 ou 5 dans lequel ledit bord externe (16b') de l'électrode d'émetteur d'étage interne (16) s'étend vers l'extérieur de ladite distance prédéterminée (72) à partir du bord externe (74) de la couche d'émetteur d'étage interne (30).

8. Thyristor selon la revendication 1, 2, 3, 4 ou 5, dans lequel le bord externe (16b') de l'électrode d'émetteur d'étage interne (16) s'étend vers l'extérieur de ladite distance prédéterminée (72') à partir du bord externe de la couche d'émetteur d'étage interne (30).

9. Thyristor selon l'une quelconque des revendications précédentes dans lequel la région d'émetteur de résistance de régulation (20) comprend au moins deux zones, la zone externe ayant une résistance plus élevée que la zone interne.

10. Thyristor selon la revendication 9, dans lequel la zone externe de la région de résistance de régulation de courant (20) est plus mince que la zone interne de la région de résistance de régulation de courant.

FIG. 1

FIG. 2

FIG. 3

1

FIG.4A

FIG.4B

FIG.4C

FIG. 5

FIG. 6

EP 0 190 162 B1